(19) Europäisches Patentamt
European Patent Office
Office européen des brevets

(11) **EP 2 472 575 A2**

(12) **EUROPEAN PATENT APPLICATION**

(43) Date of publication:
**04.07.2012 Bulletin 2012/27**

(51) Int Cl.:
**H01L 21/67** *(2006.01)*

(21) Application number: **11010201.9**

(22) Date of filing: **22.12.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **28.12.2010 JP 2010292762
20.07.2011 JP 2011158647**

(71) Applicant: **Tokyo Electron Limited
Tokyo 107-6325 (JP)**

(72) Inventors:
• **Sawada, Ikuo**
**Nirasaki City**
**Yamanashi 407-0192 (JP)**
• **Hosaka, Shigetoshi**
**Nirasaki City**
**Yamanashi 407-0192 (JP)**

(74) Representative: **Diehl & Partner GbR
Patentanwälte
Augustenstrasse 46
80333 München (DE)**

(54) **Heat treatment apparatus**

(57) A heat treatment apparatus (1, 201, 301, 401) for heat treating a plurality of substrates (S), includes: a processing chamber (22, 202, 402) which accommodates the substrates (S); a substrate holding member (24) which holds the substrates (S) in a vertical arrangement and is capable of being loaded into/unloaded from the processing chamber (22, 202, 402); an induction heating coil (104, 212, 453) which forms an induction magnetic field for induction heating in the processing chamber (22, 202, 402); a high frequency power supply (110, 214, 460) which applies high frequency power to the induction heating coil (104, 212, 453); and induction heating bodies (N, N', N") including spiral-shaped parts which are respectively installed to overlap with the substrates (S) in the processing chamber (22, 202, 402) and generate heat by a flow of induction current generated by applying the high frequency power to the induction heating coil (104, 212, 453).

FIG. 1

EP 2 472 575 A2

## Description

## TECHNICAL FIELD

The present disclosure relates to a heat treatment apparatus for heat treating a substrate in a processing chamber.

## BACKGROUND

When heat treating substrates such as semiconductor wafers and the like, for example, a film forming treatment, oxidation treatment or the like, a batch type vertical heat treatment apparatus can be used where a plurality of substrates are vertically arranged in a multistage vertical processing chamber made of quartz. The substrates are then heated by a cylindrical resistive heater installed around the processing chamber.

However, in such vertical heat treatment apparatuses, since the substrates are heated from outside of the processing chamber using the resistive heater, the quartz processing chamber (having high heat capacity) is also heated thereby providing low energy efficiency. In addition, since a wall of the processing chamber is heated to almost the same temperature as the substrates, reaction products generated by raw material gases are deposited on the inner wall of the processing chamber, particularly in a film forming process, which results in a deficiency of the raw material gas supplied to the substrates and adhesion of the reaction products deposited on the inner wall of the processing chamber to the substrates.

In addition, since it is necessary to prevent unnecessary diffusion of impurities due to miniaturization of semiconductor devices, fast increase/decrease in temperature is required. Further, although, a GaN-based semiconductor device in recent studies is formed in a vertical heat treatment apparatus by using epitaxial growth, this also requires fast increase/decrease in temperature and further heating of the device to a high temperature of more than 1000 degrees C. However, in conventional vertical heat treatment apparatuses, since a processing chamber having high heat capacity is also heated, it is difficult to meet the requirements for fast increase/decrease in temperature. It is also difficult for a resistive heater to deal with a high temperature of more than 1000 degrees C.

Induction heating may be used as a technique for solving the above problems. That is, in a heat treatment apparatus using such induction heating, an induction heating coil is provided outside of a processing chamber made of a dielectric, a heating body is provided below substrates arranged within the processing chamber, and the heating body is inductively heated by supplying high frequency power to the induction heating coil so that the substrates can be heated by heat emitted from the heating body. When the substrates are heated by the induction heating body emitting the heat through the induction heating in this manner, since the processing chamber having high heat capacity is hardly heated and the heating capability for the substrates is high, fast increase/decrease in temperature is possible thereby being able to deal with a high temperature of more than 1000 degrees C and accordingly solve the problem accruing from heating of the processing chamber.

However, when a heating body has a shape corresponding to the substrates, for example, a disc-like smooth heating body, is installed, an induction current flows into only the periphery of the heating body due to the surface effect and accordingly only the periphery of the heating body is heated without heating a central portion of the heating body, which makes it difficult to heat the substrates uniformly.

In order to solve such a problem, according to a related art, a notched groove is formed in an induction heating body so that an induction current can flow into the heating body.

When the notched groove is formed in the heating body, the central portion of the heating body can radiate heat, thereby increasing temperature uniformity over a smooth heating body. However, since hot spots are generated in a leading end of the groove, it is difficult to obtain sufficient temperature uniformity. In addition, when the induction current flows into the heating body, a counter electromotive force is unavoidably generated, which results in a low total quantity of heat and low heat efficiency.

## SUMMARY

According to a first aspect of the present disclosure, there is provided a heat treatment apparatus for heat treating a plurality of substrates. The heat treatment apparatus includes: a processing chamber which accommodates the plurality of substrates to be subjected to the heat treatment; a substrate holding member which holds the plurality of substrates in a vertical arrangement and is capable of being loaded into/unloaded from the processing chamber; an induction heating coil which forms an induction magnetic field for induction heating in the processing chamber; a high frequency power supply which applies high frequency power to the induction heating coil; and induction heating bodies having spiral-shaped parts which are installed to overlap with each other on the plurality of substrates in the processing chamber and generate heat by a flow of induction current generated by applying the high frequency power to the induction heating coil.

According to a second aspect of the present disclosure, there is provided a heat treatment apparatus for heat treating a substrate. The heat treatment apparatus includes: a processing chamber which accommodates the substrate to be subjected to the heat treatment; a substrate holding part which holds one or more substrates in the processing chamber; an induction heating coil which forms an induction magnetic field for induction heating in the processing chamber; a high frequency power supply which applies high frequency power to the induction heating coil; and induction heating bodies having spiral-shaped parts which are installed to correspond to the substrates in the processing chamber and generate heat by a flow of induction current generated by applying the high frequency power to the induction heating coil.

According to a third aspect of the present disclosure, there is provided a heat treatment apparatus for heat treating a substrate. The heat treatment apparatus includes: a processing chamber which accommodates the substrate to be subjected to the heat treatment; a substrate holding part which holds one or more substrates in the processing chamber; an induction heating coil which forms an induction magnetic field for induction heating in the processing chamber; a high frequency power supply which applies high frequency power to the induction heating coil; and induction heating bodies having spiral-shaped parts which are installed to correspond to the substrate in the processing chamber and generate heat by a flow of induction current generated by applying the high frequency power to the induction heating coil, wherein the induction heating bodies include a first heating body installed at a position corresponding to an inner side of the substrate holding part and a second heating body installed in the outer side of the substrate holding part, the first heating body and the second heating body being configured such that two spiral-shaped bodies overlap with each other, with one end of each of the two spiral shaped bodies being connected to each other and the other ends of each of the two spiral shaped bodies being connected to each other, and the two spiral-shaped bodies being configured such that an induction current flows in the same direction, and wherein the induction heating coil includes a first induction heating coil installed at a position corresponding to the first heating body and a second induction heating coil installed at a position corresponding to the second heating body, and quantities of heat of the first and second heating bodies are independently adjusted by controlling a current distribution of the first induction heating coil and the second induction heating coil.

## BRIEF DESCRIPTION OF THE DRAWINGS

The accompanying drawings, which are incorporated in and constitute a part of the specification, illustrate embodiments of the present disclosure, and together with the general description given above and the detailed description of the embodiments given below, serve to explain the principles of the present disclosure.

FIG. 1 is a longitudinal sectional view showing a heat treatment apparatus according to a first embodiment of the present disclosure.
FIG. 2 is a cross sectional view showing the heat treatment apparatus according to the first embodiment of the present disclosure.
FIG. 3 is a plan view showing an induction heating body.
FIG. 4 is a sectional view showing an induction heating body.
FIG. 5 is a plan view showing another induction heating body.
FIG. 6 is a sectional view showing another induction heating body.
FIG. 7 is a view showing a flow of induction current of the induction heating body shown in FIGS. 5 and 6.
FIG. 8 is a schematic view showing a uniform heating member installed between an induction heating body and a substrate.
FIG. 9 is a sectional view showing a layout in which a distance between an induction heating body and a substrate becomes larger from the central portion of the substrate to the outside of the substrate.
FIG. 10 is a sectional view showing that the spiral line of an induction heating body becomes dense from the central portion of the substrate to the outside of the substrate.
FIG. 11 is a sectional view showing that the diameter of the spiral line of an induction heating body becomes larger from the outside of the substrate to the central portion of the substrate.
FIG. 12 is a sectional view showing a heat treatment apparatus according to a second embodiment of the present disclosure.
FIG. 13 is a sectional view showing a modification of the heat treatment apparatus shown in FIG. 12.
FIG. 14 is a sectional view showing another modification of the heat treatment apparatus shown in FIG. 12.
FIG. 15 is a sectional view showing a heat treatment apparatus according to a third embodiment of the present disclosure.
FIG. 16 is a plan view showing a substrate loading table of the heat treatment apparatus according to the third embodiment of the present disclosure.
FIG. 17 is a sectional view showing a heat treatment apparatus according to a fourth embodiment of the present disclosure.
FIG. 18 is a view showing an arrangement of a first heating body and a second heating body of an induction heating body used in the fourth embodiment of the present disclosure.
FIG. 19 is a sectional view of an induction heating body used in the fourth embodiment of the present disclosure.
FIG. 20 is a plan view showing a second heating body.
FIG. 21 is a view showing a current distribution of an induction heating coil used in the fourth embodiment of the present disclosure.
FIG. 22 is a sectional view showing a modification of the heat treatment apparatus shown in FIG. 17.
FIG. 23 is a view showing another current distribution of an induction heating coil in the heat treatment apparatus shown in **FIG. 17.**

## DETAILED DESCRIPTION

Embodiments of the present disclosure will now be described in detail with reference to the accompanying drawings.

<First Embodiment>

First, a first embodiment of the present disclosure will be described. A vertical heat treatment apparatus for heat treating a plurality of substrates vertically arranged in a processing chamber is described.

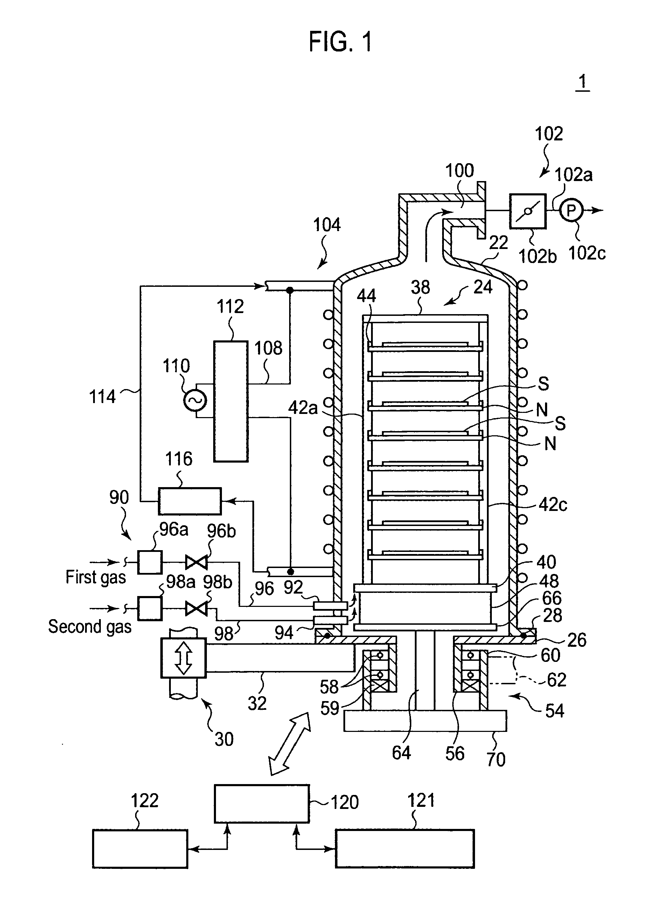

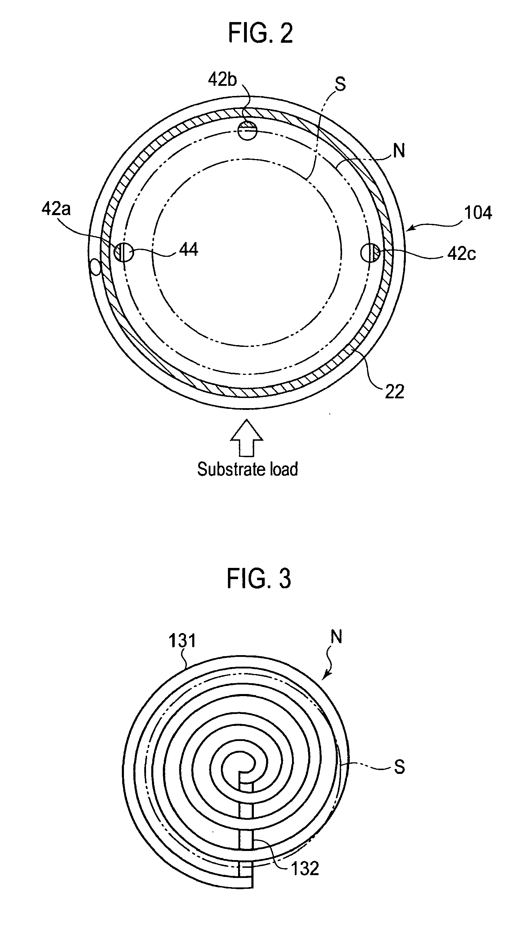

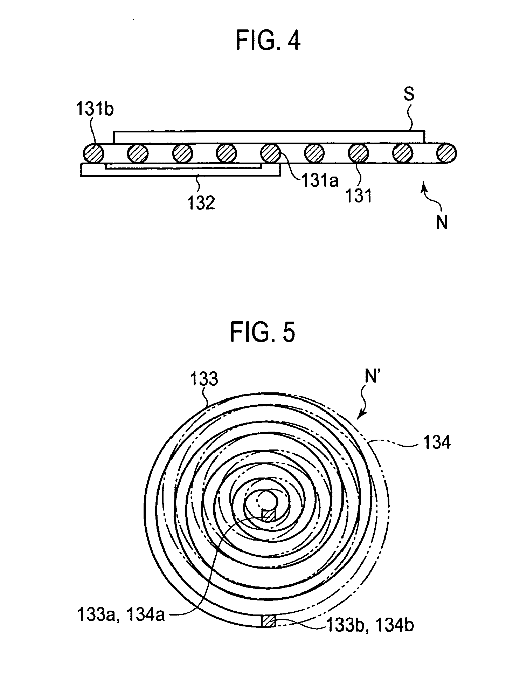

**FIG. 1** is a longitudinal sectional view showing a heat treatment apparatus according to the first embodiment of the present disclosure, **FIG. 2** is a cross sectional view of the heat treatment apparatus, **FIG. 3** is a plan view showing an induction heating body, and **FIG. 4** is a sectional view showing an induction heating body. As shown in **FIG. 1,** a heat treatment apparatus 1 includes a cylindrical vertical processing chamber 22 which vertically extends and has an open bottom. The processing chamber 22 is made of heat-resistant dielectric material pervious to electromagnetic waves (high frequency power), for example, quartz.

The processing chamber 22 includes a substrate holding member 24 holding and supporting a plurality of induction heating bodies N vertically arranged at predetermined pitches, and holding and supporting a substrate S in a state that the substrate S is loaded on each induction heating body N, which can be inserted from the bottom portion of the processing chamber. Each substrate S is mainly heated by the induction heating body N positioned below the substrate. When the substrate holding member 24 is inserted, an opening of the bottom of the processing chamber 22 is airtightly closed by a cover 26 made of, for example, quartz or stainless steel. Between the bottom of the processing chamber 22 and the cover 26 is interposed a seal member 28 such as an O-ring to provide airtightness. Both the cover 26 and the substrate holding member 24 are supported to a leading end of an arm 32 located on an elevation mechanism 30 such as a boat elevator, in such a manner that the substrate holding member 24 and the cover 26 can be integrally elevated.

The substrate holding member 24 is entirely made of heat-resistant insulative material such as quartz and formed as a holding boat. As shown in **FIG. 2,** the substrate holding member 24 includes a ring-like ceiling plate 38, a ring-like floor plate 40 and three supports 42a, 42b and 42c (only two shown in **FIG. 1**) disposed between the ceiling plate 38 and the floor plate 40. The three supports 42a to 42c are arranged at an equal interval along a semicircular region in a plane (see **FIG. 2**) and the induction heating bodies N and the substrates S are carried in/out through the opposite semicircular region.

Grooves 44 for holding the peripheries of the induction heating bodies N are formed at the same pitch along a longitudinal direction in the inner sides of the supports 42a to 42c. As the peripheries of the induction heating bodies N are supported by the grooves 44, the plurality of (for example, 10 to 55) induction heating bodies can be supported at the same pitch in a multi-stage.

The substrate holding member 24 can be rotated by a rotation mechanism 54 installed on the cover 26 at the bottom of the member 24. Specifically, the rotation mechanism 54 includes a cylindrical fixing sleeve 56 which downwardly extends from the central portion of the cover 26 and the cylindrical fixing sleeve 56 is in communication with the processing chamber 22. A cylindrical rotating member 60 is rotatably mounted on the outer circumference of the fixing sleeve 56 through a bearing 58. A driving belt 62 run by a driving source (not shown) is hung over the rotating member 60 which is rotated as the driving belt 62 is driven.

Below the bearing 58, a magnetic fluid seal 59 is installed between the fixing sleeve 56 and the rotating member 60, so that the airtightness of the processing chamber 22 can be maintained even when the rotating member 60 is rotated.

A rotating shaft 64 is provided to be inserted through the fixing sleeve 56. A rotating table 66 with its central portion opened is fixedly attached to the upper portion of the rotating shaft 64. On the rotating table 66 is mounted a cylindrical heat insulating tube 48 which is made of, for example, quartz, and the substrate holding member 24 is mounted on the heat insulating tube 48.

The rotating member 60 and the rotating shaft 64 are fixed to a base plate 70. The substrate holding member 24 is rotated around the rotating shaft 64 as the rotating member 60 is rotated by means of the driving belt 62 run by the driving source (not shown).

As shown in **FIG. 1,** a gas supplying mechanism 90 for introducing gas required for heat treatment, for example, film forming processing, in the processing chamber 22 is installed in the lower portion of the processing chamber 22. The gas supplying mechanism 90 includes first and second gas nozzles 92 and 94 which are made of, for example, quartz, and extend from the exterior to the interior of the processing chamber 22 through a side wall of the processing chamber 22. Gas supplying pipes 96 and 98 are connected to the first and second gas nozzles 92 and 94, respectively. On these supplying pipes 96 and 98 are sequentially placed opening/closing valves 96b and 98b and flow rate regulators 96a and 98a such as mass flow controllers, respectively, so that first gas and second gas required for heat treatment can be introduced with their flow rates controlled. Depending on heat treatment, the number of gas species and gas nozzles is further increased. For example, depending on the type of heat treatment, the number of types of gas used is one, in which case the number of gas supplying pipes is one. Examples of the film forming processing as the heat treatment includes CVD film forming of silicon, silicon nitride, silicon oxide and the like, epitaxial growth of GaN and the like, etc. The heat treatment is not limited to the film forming processing but may include oxidation, annealing and other processing. Depending on these types of processing, a semiconductor substrate, a sapphire substrate, a ZnO substrate, a glass substrate and other substrates is used as the substrate S.

An L-shaped exhaust port 100 which is horizontally bent is installed on the ceiling of the processing chamber 22. An exhaust system 102 for exhausting the interior of the processing chamber 22 is installed on the exhaust port 100. The exhaust system 102 includes an exhaust passage 102a connected to the exhaust port 100, a pressure control valve 102b disposed on the exhaust passage 102a, and an exhaust pump 102c which is connected to the exhaust passage 102a and exhausts the interior of the processing chamber 22 through the exhaust passage 102a. Depending on the types of processing, the processing is performed in a pressure range from a low pressure vacuum to the atmospheric pressure and accordingly the exhaust system 102 controls the internal pressure of the processing chamber 22 in a range from a high vacuum up to near atmospheric pressure.

An induction heating coil 104 is installed on the outside of the processing chamber 22. The induction heating coil 104 is formed of a metal pipe vertically wound into a spiral shape on the circumference of the processing chamber 22, with its vertical winding area being wider than an area in which the substrates S are accommodated.

The induction heating coil 104 is formed of a metal pipe either sparsely wound with a gap or compactly wound with no gap. The metal pipe forming the induction heating coil 104 is appropriately made of copper.

A power supplying line 108 extending from a high frequency power supply 110 is connected to upper and lower ends of the induction heating coil 104 and high frequency power is applied from the high frequency power supply 110 to the induction heating coil 104. An impedance matching circuit 112 is installed on the middle of the power supplying line 108.

When the high frequency power is applied to the induction heating coil 104, a magnetic field is induced within the processing chamber 22 and an induction current generated by the induced magnetic field flows into the induction heating bodies N held by the substrate holding member 24, thereby heating the induction heating bodies N. A frequency of the high frequency power supply 110 is set to a range of, for example, 0.5 to 50 kHz, preferably 1 to 5 kHz.

A refrigerant passage 114 is also connected to both ends of the metal pipe forming the induction heating coil 104, a cooler 116 is connected to the refrigerant passage 114, and the induction heating coil 104 is cooled by flowing a refrigerant from the cooler 116 into the metal pipe forming the induction heating coil 104 through the refrigerant passage 114. An example of the refrigerant used includes coolant.

The induction heating body N is made of a heatable conductor and, as shown in a plan view of **FIG. 3** and a sectional view of **FIG. 4,** includes a spiral-shaped body 131 having a diameter larger than that of the substrate S, and a returning part 132 connecting a central end 131a and a circumferential end 131 b of the body 131. When the central end 131 a is connected to the circumferential end 131b by the returning part 132, a closed loop is formed to allow the induction current to flow into the induction heating bodies N, thereby heating the induction heating bodies N.

The body 131 is made of nonmagnetic conductive material which has high thermal conductivity and can be inductively heated by the high frequency power. The material of the inductive heating bodies N has high thermal conductivity of, for example, 5W/mk or above, and in some embodiments 100 W/mk or above. If the thermal conductivity is lower than 5 W/mk, the uniformity of temperature within the plane of the induction heating bodies N tends deteriorate, which results in insufficient uniformity of temperature within the plane of the substrates. An example of such material includes carbon graphite, SiC or the like which can be appropriately used for the induction heating bodies N.

In order to obtain good efficiency by making a counter electromotive force small when the induction current flows into the induction heating bodies N, in some embodiments a sectional area and/or electrical conductivity of the returning part 132 is larger than that of the body 131. When the returning part 132 has the same sectional area as the body 131, in some embodiments the electrical conductivity of the returning part 132 is higher by one order or above than that of the body 131. If the body 131 is made of carbon graphite, since its electrical conductivity falls within a range of $1 \times 10^3$ to $1 \times 10^6$ (S/m), in some embodiments the returning part 132 is made of material having an electrical conductivity of $1 \times 10^4$ to $1 \times 10^7$ (S/m). If the body 131 is made of such carbon graphite, the returning part 132 is made of carbon graphite having an electrical conductivity higher than that of the body 131.

The above-mentioned components of the heat treatment apparatus 1 are controlled by a control unit 120 including a microprocessor (or a computer). The control unit 120 is connected with a keyboard for allowing an operator to perform input manipulation such as command input and so on for management of the heat treatment apparatus 1, and a user interface 121 composed of a display or the like for visualizing and displaying the running situations of the heat treatment apparatus 1. The control unit 120 is also connected to a storage unit 122 storing control programs for realizing various processes to be executed in the heat treatment apparatus 1 under control of the control unit 120, and programs, i.e., process recipes, for causing various components of the heat treatment apparatus to perform their respective processes depending on their respective processing conditions.

The process recipes are stored in a storage medium of the storage unit 122. Examples of the storage medium used includes a hard disk or a semiconductor memory contained in the computer, or a transferable (or portable) memory such as a CD-ROM, DVD, flash memory or the like. Alternatively, the recipes is appropriately transmitted from other external apparatuses via their respective dedicated lines. If necessary, any process recipe is called from the storage unit 122 according to an instruction from the user interface 121 and then executed by the control unit 120 so that a desired process can be performed in the heat treatment apparatus 1 under control of the control unit 120.

Next, heat treatment performed by the above-configured heat treatment apparatus 1 will be described.

A plurality of induction heating bodies N is mounted in advance on the substrate holding member 24 by means of a fork (not shown). With the substrate holding member 24 unloaded by being lowered down into the processing chamber 22, the substrates S are moved and mounted on the induction heating bodies N by means of a moving and mounting fork (not shown) and held by the substrate holding member 24. The induction heating bodies N is successively used over a plurality of batch processes, in which case the bodies can be together cleaned with dry cleaning in the processing chamber 22.

When the movement and mount of the substrate S is completed thus, the elevation mechanism 30 is driven to raise the substrate holding member 24 to be loaded into the processing chamber 22 through the opening of the bottom of the processing chamber 22. Then, the opening in the bottom of the processing chamber 22 is sealed by the cover 26 to make the interior of the processing chamber 22 airtight.

Next, the high frequency power supply 110 is turned on to apply high frequency power to the induction heating coil 104 formed of the wound metal pipe, thereby inducing a magnetic field in the processing chamber 22. This induced magnetic field allows an induction current to flow into the induction heating bodies N held by the substrate holding member 24, thereby heating the induction heating bodies N. When the induction heating bodies N are heated in this way, the substrate S arranged adjacent thereto is heated to increase their temperature by virtue of heat emitted from the induction heating bodies N.

At the same time, while rotating the substrate holding member 24 with a predetermined number of rotations by means of the rotation mechanism 54, the first and second gases (for example, film forming gases) required for heat treatment are supplied from the first and second gas nozzles 92 and 94 of the gas supplying mechanism 90, respectively, with their flow rates controlled. The internal atmosphere of the processing chamber 22 is controlled by the exhaust system 102 through the exhaust port 100 provided in the ceiling of the processing chamber 22 so that the internal atmosphere of the processing chamber 22 can keep at a predetermined process pressure. At this time, the temperature of the substrates S is measured by a thermocouple (not shown) provided in the processing chamber 22 and, for example, a film forming process is performed while adjusting the temperature of the substrates S to a predetermined process temperature by controlling the high frequency power based on the measured temperature. Since the temperature of the induction heating coil 104 increases during the film forming process, the cooler 116 flows a refrigerant such as a coolant or the like into the induction heating coil 104 to be cooled. In this case, an inner wall of the processing chamber 22 is cooled in order to prevent a film from adhering to the inner wall, although such film adhesion depends on reaction conditions of the film forming gases.

When the induction heating bodies N are heated by the inductive heating as in this embodiment and the substrates S are heated by the heat emitted from the induction heating bodies N, since the processing chamber 22 formed of a dielectric and having a high heat capacity is hardly heated and has high heating capability, the substrates S can increase/decrease in temperature at a high speed and can be sufficiently heated to a high temperature of 1000 degrees C or above.

In addition, since such a processing chamber 22 having the high heat capacity is hardly heated, power consumption can be reduced. In addition, sine the processing chamber 22 is hardly heated, the processing chamber 22 can be kept at a low temperature, thereby preventing unnecessary film from being deposited on the inner wall of the processing chamber 22 during the film forming process, which will result in a low possibility of generating particles. Moreover, the frequency of cleanings is reduced.

However, when inductive heating using high frequency power, a majority of the induction current flows on surfaces of heating targets due to the surface effect. That is, the induction current rapidly decreases from the surfaces of heating targets. Thus, if a depth at which a strength of induction current decreases to 1/e ($\cong$0.368) of that of the surface is defined by a skin depth $\delta$, $\delta$ is expressed by the following equation 1.

[Equation 1]

$$\delta = (2/\varpi\mu o\sigma)^{1/2}$$

Where, $\varpi$ is an angular frequency ($=2\pi f$: f is a frequency), $\mu o$ is permeability and $\sigma$ is electrical conductivity (S/m).

If the induction heating bodies N as the heating targets are made of nonmagnetic material such as carbon graphite, SiC or the like, $\mu o$ is 1 and $\delta$ is within a range of several to several tens of mm in consideration of the above-mentioned range of the electrical conductivity and the frequency.

Accordingly, if the induction heating bodies N have a disc shape overlapping with the substrates S, the induction current only flows over the disc and heats only the surroundings of the induction heating bodies N, which makes it difficult to heat the substrates S uniformly.

In order to solve this problem, notch-shaped grooves are formed in the induction heating bodies such that the induction current flows into the interior of the induction heating bodies. Temperature uniformity increases to some degrees since the induction current flows into and heats the central portion of the induction heating body. However, it is difficult to obtain sufficient temperature uniformity due to hot spots generated in the leading end of the groove, and a counter electromotive force is unavoidably generated when the induction current flows into the induction heating body, which results in a small quantity and low efficiency of heat.

In contrast, in this embodiment, since the induction heating body N has a spiral shape and accordingly induction current flows from its center to its circumference or vice versa along a spiral line, the induction heating body N can generate heat entirely. In addition, since hot spots can be prevented from being generated by making the spiral shape smooth, the substrates S can be uniformly heated. In addition, by lowering the resistance of the returning part 132, a distribution of counter electromotive force can be prevented from being formed, thereby achieving more efficient heating. Specifically, in some embodiments, the resistance of the returning part 132 is made to be smaller than that of the body 131 by increasing the sectional area of the returning part 132 and/or making the sectional area of the returning part 132 larger than that of the spiral-shaped body 131. When the returning part 132 has the same sectional area as the body 131, the electrical conductivity of the returning part 132 can be made to be higher by one order or above than that of the body 131.

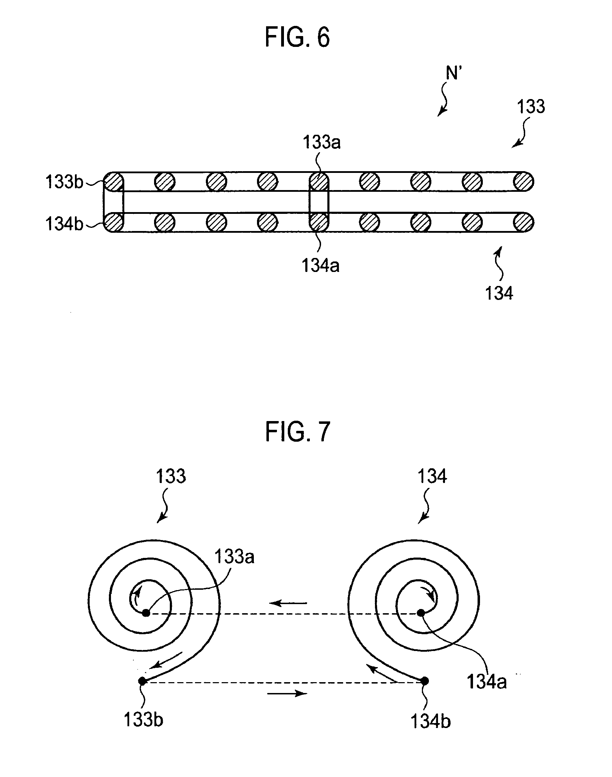

In order to heat the substrate S more uniformly by decreasing the counter electromotive force, in some embodiments, an induction heating body in which two spiral-shaped bodies such as the body 131 overlap with each other is provided. Their central ends are connected to each other and their circumferential ends are connected to each other, and these spiral-shaped bodies are configured such that induction current flows in the same direction. As shown in a plan view of **FIG. 5** and a sectional view of **FIG. 6**, a specific example includes an induction heating body N' in which one spiral-shaped body 133 overlaps with another inverted spiral-shaped body 134 having the same shape as the spiral-shaped body 133 and their central ends 133a and 134a are connected to each other and their circumferential ends 133b and 134b are connected to each other. As shown in **FIG. 7** for easy understanding of a flow of induction current at that time, for example, an induction current flows in the same direction in such an endless manner that the induction current flows clockwise from the central end 133a of the spiral-shaped body 133 to its circumferential end 133b, and subsequently flows clockwise again from the circumferential end 134b of the spiral-shaped body 134 connected to the circumferential end 133b to its central end 134a, and flows in the same direction again from the central end 133a of the spiral-shaped body 133. This can prevent a counter electromotive force from being generated, thereby achieving high-efficient and high-uniform heating.

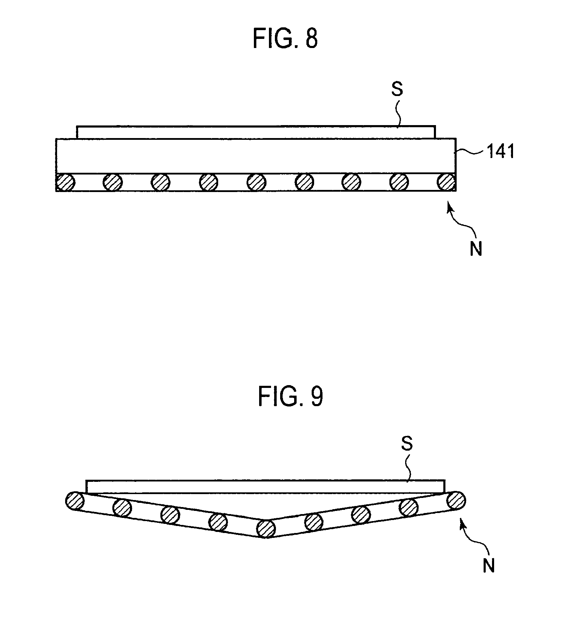

In addition, in order to achieve high-uniform heating, as shown in **FIG. 8,** in some embodiments a uniform heating member 141 between the induction heating body N (N") and the substrate S is provided. Although there is a possibility of non-uniform heating due to a temperature distribution of the substrate S corresponding to a pattern of the induction heating body N when a spiral-shaped induction heating body N directly faces the substrate S, by providing the uniform heating member 141 between the induction heating body N (N") and the substrate S, it is possible to realize a uniform temperature distribution. The uniform heating member is in some embodiments a dielectric having high thermal conductivity. Examples of such a dielectric includes AlN, $Al_2O_3$, $Si_3N_4$ and so on. Among these, AlN having particularly high thermal conductivity is suitable. Although it is shown in **FIG. 8** that the uniform heating member 141 is provided to be in contact the substrate S, it may be slightly apart from the substrate S.

In addition, the substrate S is not necessarily heated uniformly but may have a heating distribution in consideration of a difference in heating effect depending on portions of the substrate S. For example, a heating distribution is formed by varying a distance between the substrate S and the induction heating body N depending on portions of the substrate S. In the example of **FIG. 9,** a distance between the induction heating body N and the substrate S is larger in the central portion while the distance between the induction heating body N and the substrate S is smaller in the outward portion. In this case, a heating effect is smaller in the central portion while the heating effect becomes larger in the outward portion.

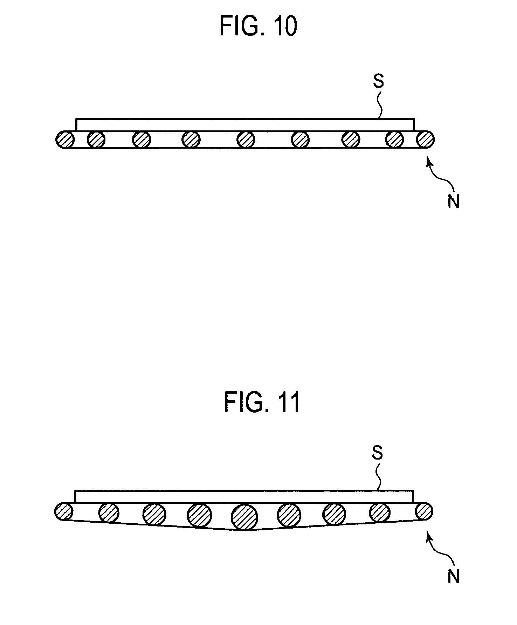

In addition, instead of uniformly providing the spiral-shaped induction heating body N, it is possible to achieve a heating distribution by changing a density of the spiral line. In the example of **FIG. 10,** the density of the spiral line of the induction heating body N is sparse in the central portion while the density of spiral line becomes compact in the outward portion. In this case, the heating effect is smaller in the central portion while the heating effect becomes larger in the outward portion.

In addition, it is possible to achieve different heating distributions by changing the diameter of the spiral line of the induction heating body N. In the example of **FIG. 11,** a diameter of the spiral line is smaller in the outward portion while the diameter of spiral line becomes larger in the inward portion. In this case, a heating effect is smaller in the central portion while the heating effect becomes larger in the outward portion.

In addition, although in the above embodiment the induction heating coil 104 is wound in the exterior of the processing chamber 22, it may be provided in the interior of the processing chamber 22. In this case, when the induction heating coil 104 is provided within a dielectric, the processing chamber 22 is made of metal.

<Second Embodiment>

Next, a second embodiment will be described. A single substrate type heat treatment apparatus for heat treating substrates one by one is here described.

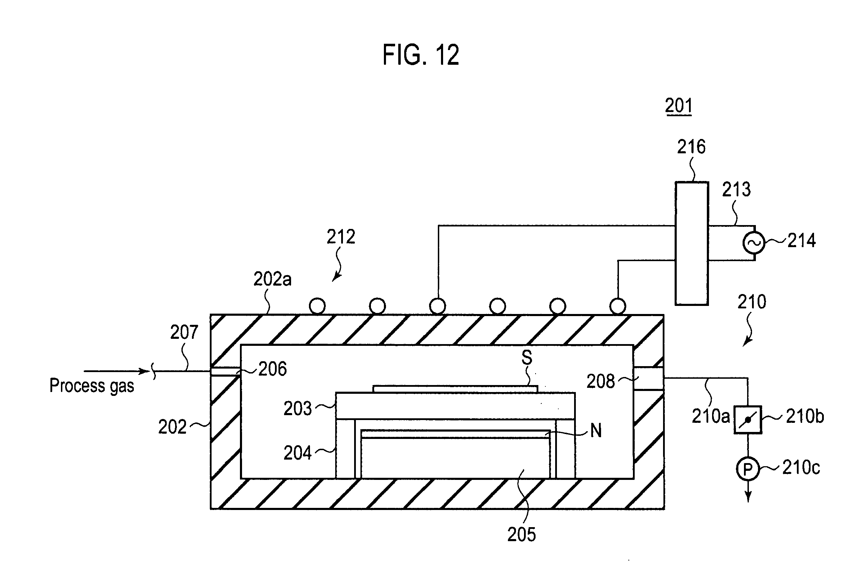

**FIG. 12** is a sectional view showing a heat treatment apparatus according to a second embodiment of the present disclosure. As shown in **FIG 12,** a heat treatment apparatus 201 includes a cylindrical processing chamber 202. The processing chamber 202 is made of heat-resistant dielectric material pervious to electromagnetic waves (high frequency power), for example, quartz. The processing chamber 202 accommodates a substrate loading table 203 for loading a substrate S supported by a leg part 204 extending from the bottom portion of the processing chamber 202. The substrate loading table 203 is in some embodiments made of a dielectric having high thermal conductivity. Examples of such a dielectric includes AlN, $Al_2O_3$, $Si_3N_4$ and so on. Among these, AlN having particularly high thermal conductivity is suitable. Although it is shown in **FIG. 12** that the substrate S is directly loaded onto the substrate loading table 203, the substrate S may be slightly apart from the substrate loading table 203.

A substrate carrying in/out hole (not shown) which can be opened/closed by a gate valve (not shown) is installed in the processing chamber 202, and substrate elevating pins (not shown) which can project/retract from/ into the top surface of the loading table 203 is installed on the loading table 203. The substrate S is carried in/out through the substrate carrying in/out hole by means of a substrate carrying arm (not shown) and the substrate elevating pins project upward from the substrate loading table 203 when the substrate S is loaded on or unloaded from the substrate loading table 203.

An induction heating body N supported by a support 205 is disposed below the substrate loading table 203 at a position corresponding to (i.e., vertically overlapping with) the substrate S loaded on the substrate loading table 203. The induction heating body N has the same configuration as the first embodiment. Instead, the induction heating body N' shown in **FIGS. 5** and **6** is used.

On a side wall of the processing chamber 202, a process gas introduction hole 206 for introducing process gas into the processing chamber 202 is formed. A process gas supplying pipe 207 is connected to the process gas introduction hole 206 such that the process gas required for heat treatment, for example, a film forming process, is introduced into the processing chamber 202. Although not shown, gas pipes depending on the number of process gases are connected to the process gas supplying pipe 207. Opening/closing valves and flow rate regulators such as mass flow controllers are installed on the gas pipes. The type and number of gases is appropriately determined depending on the heat treatment. Like the first embodiment, examples of the film forming process as the heat treatment includes CVD film forming of silicon, silicon nitride, silicon oxide and the like, epitaxial growth of GaN and the like, etc. The heat treatment is not limited to the film forming process but may include oxidation, annealing and the like. Depending on the types of treatment, a semiconductor substrate, a sapphire substrate, a ZnO substrate, a glass substrate and the like is used as the substrate S.

An exhaust hole 208 is formed at a position opposite the process gas introduction hole 206 on the side wall of the processing chamber 202, and an exhaust system 210 for exhausting the interior of the processing chamber 202 is connected to the exhaust hole 208. The exhaust system 210 includes an exhaust passage 210a connected to the exhaust hole 208, a pressure control valve 210b disposed on the exhaust passage 210a, and an exhaust pump 210c for exhausting the interior of the processing chamber 202 through the exhaust passage 210a. Depending on the types of treatment, the treatment is performed in a pressure range from low vacuum to atmospheric pressure and accordingly the exhaust system 210 controls the internal pressure of the processing chamber 202 in a range from high vacuum up to near atmospheric pressure.

An induction heating coil 212 is installed facing a ceiling wall 202a above the processing chamber 202. The induction heating coil is formed of a metal pipe wound into a plane spiral shape and covers an area wider than the substrate S having the shape of the substrate loading table 203. The metal pipe forming the induction heating coil 212 is appropriately made of copper. A power supplying line 213 extending from a high frequency power supply 214 is connected to both central and circumferential ends of the induction heating coil 212, and high frequency power is applied from the high frequency power supply 214 to the induction heating coil 212. An impedance matching circuit 216 is installed in the middle of the power supplying line 213.

By applying the high frequency power to the induction heating coil 212, a magnetic field is induced within the processing chamber 202. An induction current generated by the induced magnetic field flows into the induction heating body N in the processing chamber 202, thereby heating the induction heating body N. The frequency of the high frequency power supply 214 is set to a range of, for example, 0.5 to 50 kHz, and in some embodiments 1 to 5 kHz. A cooling gas supplying mechanism (not shown) supplies cooling gas to an inner wall of the processing chamber 202 to prevent the temperature of a wall of the processing chamber 202 from increasing.

Although not shown, the heat treatment apparatus 201 also includes a control unit, a storage unit and a user interface, like the heat treatment apparatus 1 of the first embodiment.

Next, heat treatment performed by the above-configured heat treatment apparatus 201 will be described.

First, the gate valve is opened and the substrate S is carried in the processing chamber 202 and loaded on the substrate loading table 203 through the carrying in/out hole by means of the carrying arm of the carrying device. Then, the gate valve is closed to make the interior of the processing chamber 202 airtight.

Subsequently, the high frequency power supply 214 is turned on to apply high frequency power to the induction heating coil 212, thereby emitting high frequency power from the induction heating coil 212. The high frequency power emitted from the induction heating coil 212 reaches the interior of the processing chamber 202 through the ceiling wall 202a of the processing chamber 202, thereby inducing a magnetic field within the processing chamber 202. This induced magnetic field allows an induction current to flow into the induction heating body N, thereby heating the induction heating body N. In this way, the substrate S is heated to increase its temperature by virtue of heat emitted from the induction heating bodies N.

At the same time, film forming gas required for heat treatment, for example, a film forming process, is supplied through the process gas supplying pipe 207 and the process gas introduction hole 206 with its flow rate controlled, and the internal atmosphere of the processing chamber 202 is vacuumized by the exhaust system 212 through the exhaust hole 208 so that the internal atmosphere of the processing chamber 202 can be kept at a predetermined process pressure. At this time, a temperature of the substrate S is measured by a thermocouple (not shown) installed in the processing chamber 202 and, for example, a film forming process is performed while adjusting the temperature of the substrate S to a predetermined process temperature by controlling the high frequency power based on the measured temperature. During the treatment, the cooling gas flows into the processing chamber 202 to cool an inner wall of the processing chamber 202. In this embodiment the inner wall of the processing chamber 202 is cooled in order to prevent a film from adhering to the inner wall of the processing chamber 202, although such film adhesion may depend on reaction conditions of the film forming gas.

In this way, like the first embodiment, since the induction heating body is heated by inductive heating and the substrate S is heated by the heat emitted from the induction heating body, the processing chamber 202 having a high heat capacity is hardly heated and has high heating capability, the substrate S can increase/decrease in temperature at a high speed and can be sufficiently heated to a high temperature of 1000 degrees C or above. In addition, since such a processing chamber 202 having the high heat capacity is hardly heated, power consumption can be reduced. In addition, as the processing chamber 202 is hardly heated, the inner wall of the processing chamber 202 can be kept at a low temperature, thereby preventing an unnecessary film from being deposited on the inner wall of the processing chamber 202 (particularly in case of a film forming process) which results in a low possibility of generating particles. Moreover, the frequency of cleanings is reduced.

In addition, like the first embodiment, since the induction heating body N has a spiral shape and accordingly induction current flows from its center to its circumference or vice versa along a spiral line, the induction heating body N can generate heat entirely. In addition, since hot spots can be prevented from being generated by making the spiral shape smooth, the substrate S can be uniformly heated. In addition, by lowering the resistance of the returning part 132, a distribution of counter electromotive force can be prevented from being formed, thereby achieving more efficient heating.

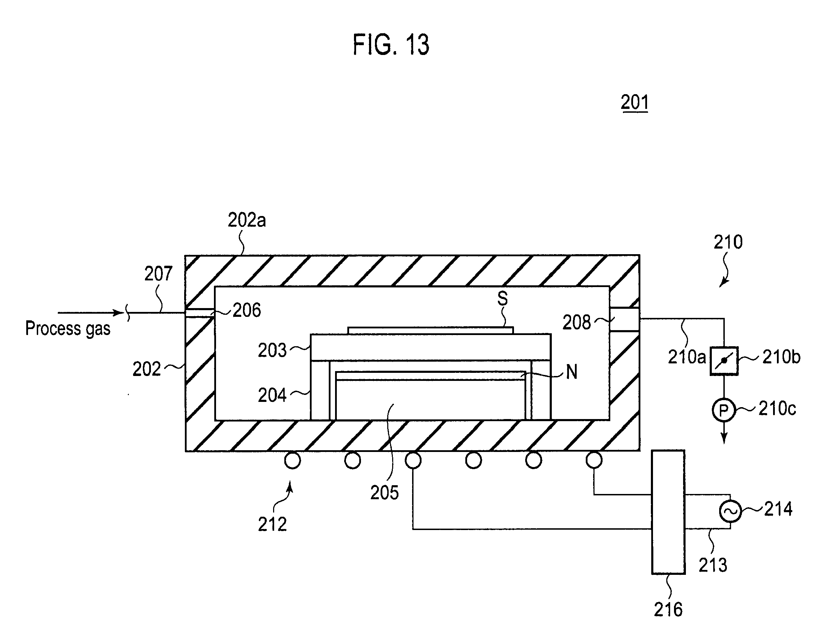

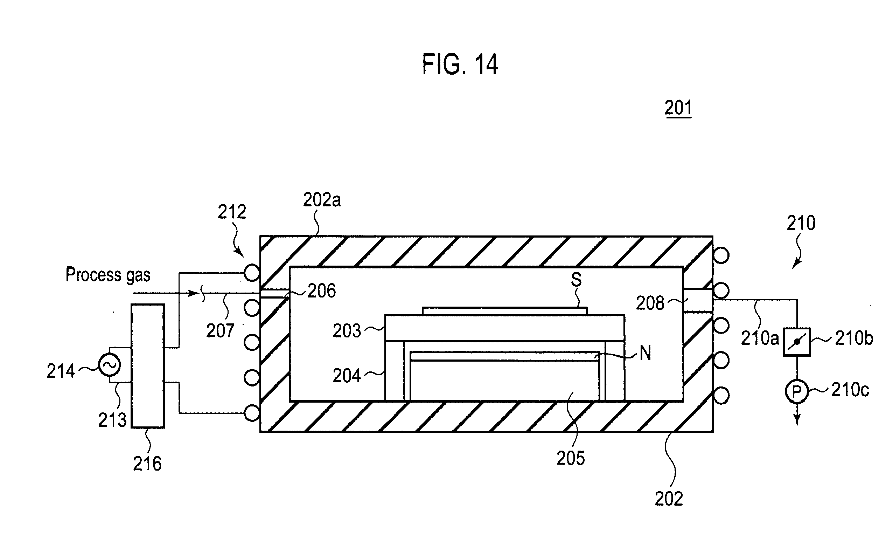

In the second embodiment, the induction heating coil 212 is not limited to being installed above the processing chamber 202, but may be installed below the processing chamber 202, as shown in **FIG. 13,** or may be wound on the side of the processing chamber 202, as shown in **FIG. 14.** However, in some embodiments the induction heating coil 212 is installed within a dielectric so that a metal member cannot generate heat. When the induction heating coil 212 is installed within the dielectric, the processing chamber 202 is made of metal.

<Third Embodiment>

Next, a third embodiment will be described. A heat treatment apparatus for heat treating a plurality of substrates at a time based on a single substrate type heat treatment apparatus of the second embodiment is described.

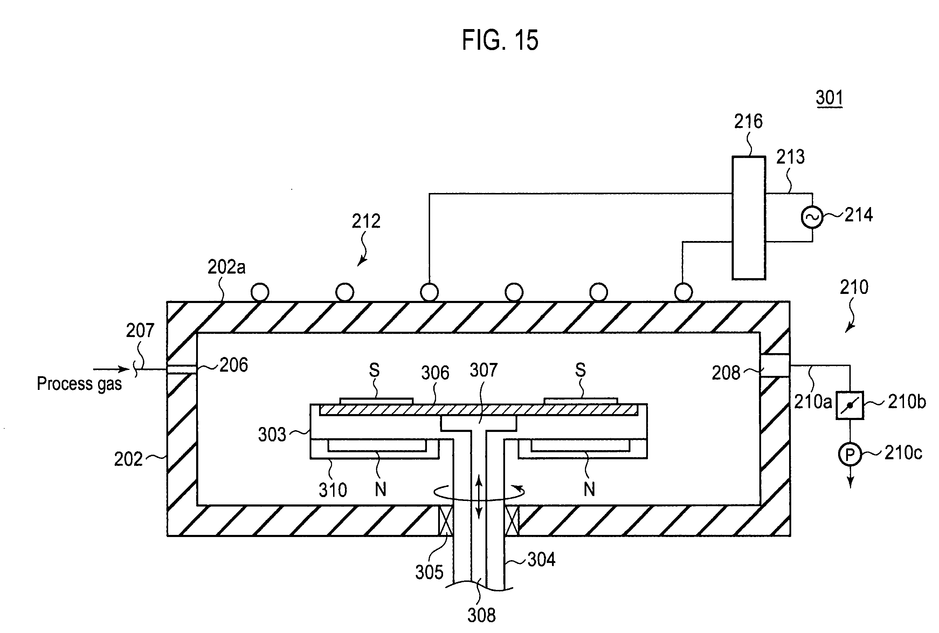

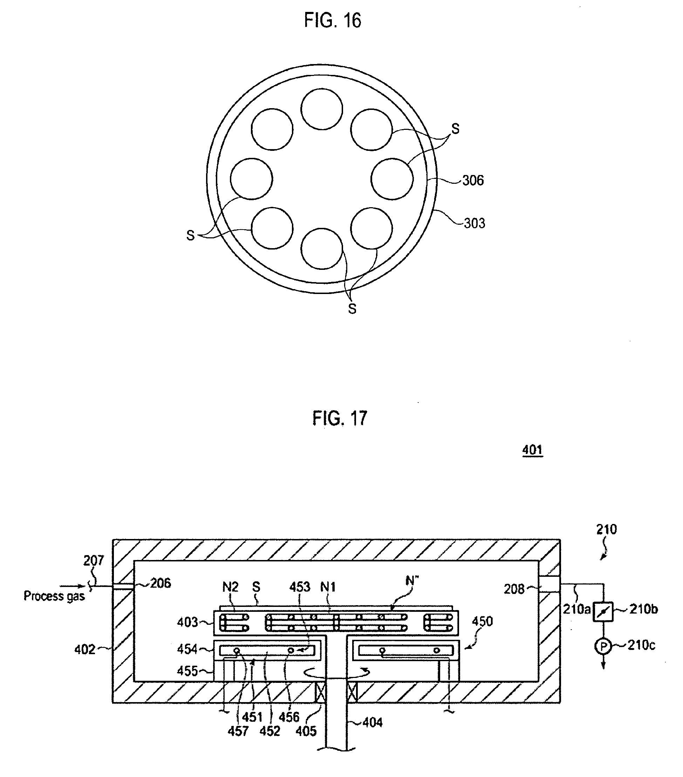

**FIG. 15** is a sectional view showing a heat treatment apparatus according to a third embodiment of the present disclosure and **FIG. 16** is a plan view showing a substrate loading table of the apparatus. This embodiment is based on the apparatus of **FIG. 12** in the second embodiment. Therefore, the same elements as **FIG. 12** are denoted by the same reference numerals, an explanation of which will not be repeated.

A heat treatment apparatus 301 of this embodiment includes a processing chamber 202 in which a disc-like substrate loading table 303 for loading a plurality of substrates S is horizontally disposed. The substrate loading table 303 is supported by a vertically extending cylindrical shaft 304 which penetrates through the bottom portion of the processing chamber 202 and is rotated by a rotation driving mechanism (not shown). The substrate loading table 303 is rotated by the rotation of the shaft 304.

A disc-like substrate carrying plate 306 having a diameter smaller than that of the substrate loading table 303 is elevatably installed on the top surface of the substrate loading table 303, and the plurality of substrates S is loaded thereon. In this example, 8 substrates S are circumferentially arranged at an equal interval. The substrate carrying plate 306 is supported by an elevating member 307 and an elevating axis 308 extends downward from the bottom surface of the elevating member 307 in the shaft 304. The substrate carrying plate 306 is elevated by an elevating mechanism (not shown) through the elevating axis 308 and the elevating member 307 such that the plurality of substrates S is carried for each carrying plate 306.

The substrate loading table 303 and the substrate carrying plate 306 can be made of a dielectric having high thermal conductivity. Examples of such a dielectric includes AlN, $Al_2O_3$, $Si_3N_4$ and so on. Among these, AlN having particularly high thermal conductivity is suitable.

A plurality of induction heating bodies N is provided on the bottom of the substrate loading table 303 at positions respectively corresponding to (i.e., vertically overlapping with) the substrates S loaded on the substrate loading table 303. The plurality of induction heating bodies N is held by an annular holding member 310. The induction heating bodies N makes contact with the bottom surface of the substrate loading table 303 or is separated therefrom. The induction heating bodies N have the same configuration as those of the first embodiment. The induction heating bodies N' shown in **FIGS. 5** and **6** is used as well.

Although not shown, the heat treatment apparatus 301 also includes a control unit, a storage unit and a user interface, like the heat treatment apparatus 1 of the first embodiment.

Next, heat treatment performed by the above-configured heat treatment apparatus 301 will be described.

First, a gate valve is opened and the substrate carrying plate 306 loading the plurality of substrates S is carried in the processing chamber 202 and loaded on the substrate loading table 303 through a carrying in/out hole by means of the carrying arm of the carrying device. Then, the gate valve is closed to make the interior of the processing chamber 202 airtight.

Subsequently, while rotating the substrate loading table 303 by means of a rotation driving mechanism (not shown), the high frequency power supply 214 is turned on to apply high frequency power to the induction heating coil 212, thereby emitting high frequency power from the induction heating coil 212. The high frequency power emitted from the induction heating coil 212 reaches the interior of the processing chamber 202 through the ceiling wall 202a of the processing chamber 202, thereby inducing a magnetic field within the processing chamber 202. This induced magnetic field allows an induction current to flow into the induction heating bodies N, thereby heating the induction heating bodies N. In this way, the substrates S are heated to increase their temperature by virtue of heat emitted from the induction heating bodies N.

At the same time, film forming gas required for heat treatment, for example, a film forming process, is supplied through the process gas supplying pipe 207 and the process gas introduction hole 206 with its flow rate controlled, and the internal atmosphere of the processing chamber 202 is vacuumized by the exhaust system 212 through the exhaust hole 208 so that the internal atmosphere of the processing chamber 202 can be kept at a predetermined process pressure. At this time, a temperature of the substrates S is measured by a thermocouple (not shown) installed in the processing chamber 202 and, for example, a film forming process is performed while adjusting the temperature of the substrates S to a predetermined process temperature by controlling the high frequency power based on the measured temperature. During the treatment, cooling gas flows into the processing chamber 202 to cool an inner wall of the processing chamber 202. In some embodiments the inner wall of the processing chamber 202 is cooled in order to prevent a film from adhering to the inner wall of the processing chamber 202, although such film adhesion may depend on reaction conditions of the film forming gas. Like the first and second embodiments, examples of the film forming process as the heat treatment may include CVD film forming of silicon, silicon nitride, silicon oxide and the like, epitaxial growth of GaN and the like, etc. The heat treatment is not limited to film forming processing but may include oxidation, annealing and the like. Depending on the types of treatment, a semiconductor substrate, a sapphire substrate, a ZnO substrate, a glass substrate and the like is used as the substrate S.

This embodiment can achieve a very high throughput since a plurality of substrates can be processed base on the single substrate type heat treatment apparatus, in addition to the same effect as the second embodiment.

In this embodiment, like the second embodiment, the induction heating coil 212 is not limited to being installed above the processing chamber 202 but may be installed below the processing chamber 202 or may be wound on the side of the processing chamber 202. In addition, the induction heating coil 212 is not limited to being installed in the exterior of the processing chamber 202 but may be installed within the processing chamber 202. However, in some embodiments the induction heating coil 212 is installed within a dielectric so that a metal member cannot generate heat. When the induction heating coil 212 is installed within the dielectric, the processing chamber 202 is made of metal.

<Fourth Embodiment>

Next, a fourth embodiment will be described. An example where, in the single substrate heat treatment apparatus of the second embodiment, induction heating bodies are installed in the inner side and the outer side in which two spiral-shaped bodies overlap with each other, their central ends are connected each other and their circumferential ends are connected each other, and these spiral-shaped bodies are configured such that induction current flows in the same direction and are inductively heated independently is described.

**FIG. 17** is a sectional view showing a heat treatment apparatus according to a fourth embodiment of the present disclosure. In **FIG. 17**, the same elements as the second embodiment shown in **FIG. 12** are denoted by the same reference numerals, an explanation of which will not be repeated.

As shown in **FIG. 17**, a heat treatment apparatus 401 includes a cylindrical processing chamber 402 which is made of metal or dielectric.

A substrate loading table 403 for loading a substrate S is horizontally disposed within the processing chamber 402. The substrate loading table 403 is supported by a vertically extending cylindrical shaft 404 which penetrates through the bottom portion of the processing chamber 402 and is rotated by a rotation driving mechanism (not shown). The substrate loading table 303 is rotated with the rotation of the shaft 404. A space between the shaft 404 and the processing chamber 402 is airtightly sealed by a fluid seal 405.

The substrate loading table 403 is made of a dielectric having high thermal conductivity. Examples of such a dielectric include AIN, $Al_2O_3$, $Si_3N_4$ and so on. Among these, AIN having particularly high thermal conductivity is suitable. Although it is shown in **FIG. 17** that the substrate S is directly loaded on the substrate loading table 403, the substrate S is slightly apart from the substrate loading table.

A substrate carrying in/out hole (not shown) which can be opened/closed by a gate valve (not shown) is installed in the processing chamber 402 and substrate elevating pins (not shown) which can project/retract from/into the top surface of the loading table 403 is installed on the loading table 403. The substrate S is carried in/out through the substrate carrying in/out hole by means of the substrate carrying arm (not shown) and the substrate elevating pins project upward from the substrate loading table 403 when the substrate S is loaded on or unloaded from the substrate loading table 403.

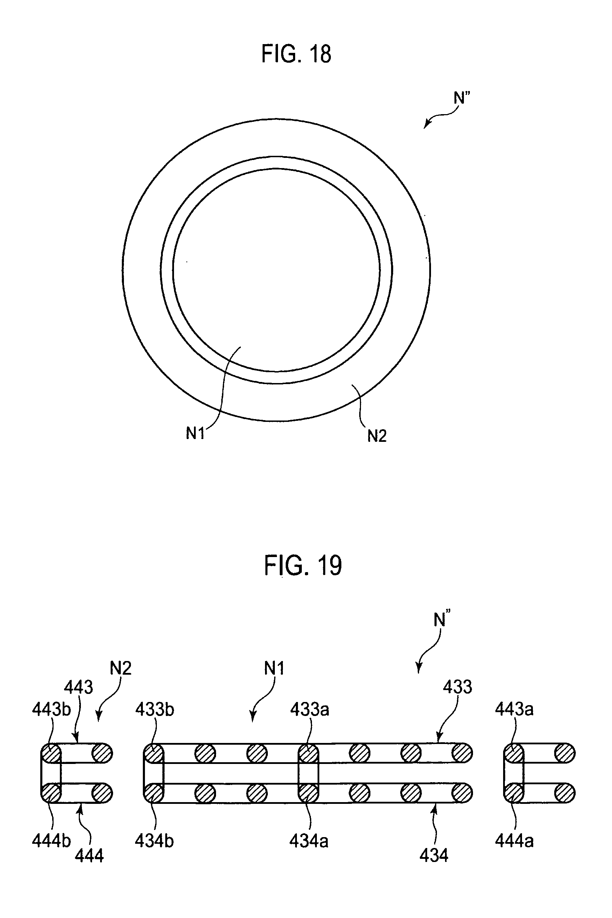

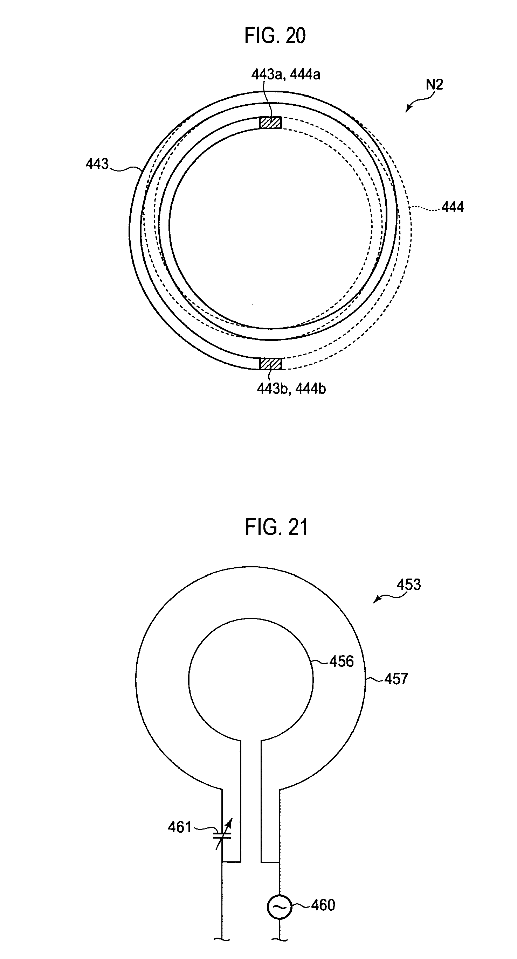

Induction heating bodies N″ are installed within the substrate loading table 403. The induction heating bodies N″ are installed in the inner side (central side) and the outer side in which two spiral-shaped bodies overlap with each other, their central ends are connected to each other and their circumferential ends are connected to each other, and these spiral-shaped bodies are configured such that induction current flows in the same direction. Specifically, as shown in a plan view of **FIG. 18**, the induction heating bodies N″ include a first heating body N1 installed in the inner side and a second heating body N2 installed in the outer side. The first heating body N1 has the same configuration as the heating body N' shown in **FIGS. 5** and **6**. That is, as shown in **FIG. 19**, in the first heating body N1, one spiral-shaped body 433 like the spiral-shaped body 133 overlaps with another inverted spiral-shaped body 434 having the same shape as the spiral-shaped body 433 and their inner side ends (central side ends) 433a and 434a are connected to each other and their outer side ends 433b and 434b are connected to each other. As shown in **FIGS. 19** and **20**, also in the second heating body N2, one spiral-shaped body 443 installed in the outer side of the spiral-shaped body 433 overlaps with another inverted spiral-shaped body 444 having the same shape as the spiral-shaped body 443 and their inner side ends 443a and 444a are connected to each other and their outer side ends 443b and 444b are connected to each other.

An induction heater 450 is disposed below the substrate loading table 403 (the induction heating bodies N") in the processing chamber 402. The induction heater 450 includes an induction heating coil unit 451 composed of an annular dielectric member 452 made of a dielectric such as quartz and an induction heating coil 453 installed in the dielectric member 452. The induction heating coil unit 451 is held by an annular holding member 454 supported by a leg part 455 which vertically extends from the bottom portion of the processing chamber 402.

As shown in **FIG. 21**, the induction heating coil 453 includes a first induction heating coil 456 installed at a position corresponding to the inner first heating body N1 and a second induction heating coil 457 installed at a position corresponding to the outer second heating body N2.

High frequency power is supplied from a common high frequency power supply 460 into the first induction heating coil 456 and the second induction heating coil 457. A variable capacitor 461 is interposed between the first induction heating coil 456 and the second induction heating coil 457 by which a current distribution between the first induction heating coil 456 and the second induction heating coil 457 can be adjusted.

Although not shown, the heat treatment apparatus 401 also includes a control unit, a storage unit and a user interface, like the heat treatment apparatus 1 of the first embodiment.

A gas supplying system and an exhaust system has the same configuration as those of **FIG. 12** and therefore are denoted by the same reference numerals, an explanation of which will not be repeated.

In the above-configured heat treatment apparatus of the fourth embodiment, since the induction heating bodies N″ are divided into the inner (central) first heating body N1 and the outer second heating body N2, the induction heating coil 453 includes the first induction heating coil 456 and the second induction heating coil 457, and the current distribution between the first induction heating coil 456 and the second induction heating coil 457 can be adjusted by adjusting the variable capacitor 461, it is possible to control heating of the central portion and the circumferential portion of the substrate S independently by adjusting the quantity of heat of the first and second heating bodies N1 and N2 through control of the variable capacitor by the control unit.

In addition, since the first and second heating bodies N1 and N2 constituting the induction heating bod-

ies N″ are composed of two spiral-shaped bodies that overlap with each other, their central ends are connected to each other and their circumferential ends are connected to each other, and these spiral-shaped bodies are configured such that induction current flows in the same direction, a counter electromotive force can be prevented from being generated, which results in very high-efficient and uniform heating.

Accordingly, the heat treatment apparatus of this embodiment can realize uniform heating even for a large-sized substrate S and also a desired temperature distribution depending on process conditions.

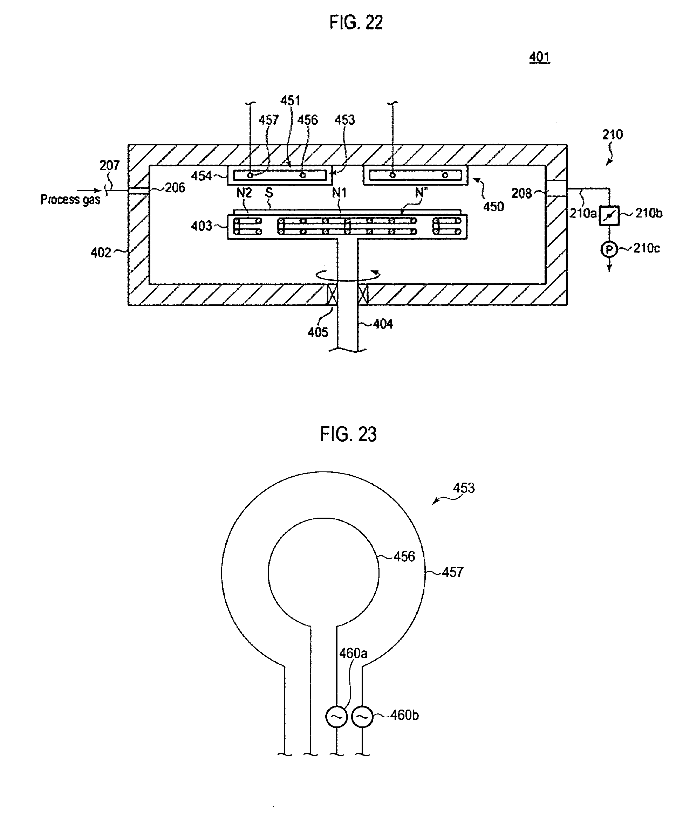

Although it is shown in **FIG. 17** that the induction heating coil unit 451 is disposed below the induction heating bodies N″, its position is not limited thereto as long as it can adjust the quantity of heat of the first and second heating bodies N1 and N2. For example, the induction heating coil unit 451 is disposed above the induction heating bodies N″, as shown in **FIG. 22.** In addition, although it is illustrated that the current distribution between the first induction heating coil 456 and the second induction heating coil 457 is adjusted by adjusting the variable capacitor 461, this current distribution is adjusted by adjusting outputs of high frequency power supplies 460a and 460b installed separately in the first induction heating coil 456 and the second induction heating coil 457, as shown in **FIG. 23.** In addition, like the third embodiment, a plurality of substrates loaded on the substrate loading table 403 is processed. In this case, it is possible to perform a uniform process for the plurality of substrates. In addition, although the substrate loading table 403 is configured to be rotated in the apparatus shown in **FIG. 17**, it may not be necessarily rotated. In addition, although the induction heating bodies are divided into the inner first heating body and the outer second heating body, they may be divided into three or more heating bodies.

<Other Applications>

The present disclosure is not limited to the above-described embodiments but may be modified in various ways. For example, although the heat treatment has been illustrated with a film forming process, an oxidation and an annealing, it may include diffusion, surface modification, etching and the like provided that they involve substrate heating. The supply of gas is not essential in the heat treatment of the present disclosure. Although the substrate used has been illustrated with a semiconductor substrate, a sapphire substrate, a ZnO substrate, a glass substrate and the like depending on types of the treatment, the substrate is not particularly limited. In addition, although in the above embodiments the material of the induction heating bodies has been illustrated with carbon graphite and SiC, the material is not limited thereto but may be conductive ceramics (conductive SiN or the like) other than glassy carbon and SiC.

According to the present disclosure in some embodiments, since an induction current flows into the induction heating body having a spiral shape installed corresponding to a substrate in the processing chamber, the induction current can flow from the center to the circumference of the induction heating body or vice versa along a spiral line, thereby allowing the induction heating body to generate heat entirely. In addition, hot spots can be prevented from being generated by making the spiral shape smooth, thereby allowing the substrate to be uniformly heated. In addition, a distribution of counter electromotive force can be prevented from being formed, thereby achieving more efficient heating.

While certain embodiments have been described, these embodiments have been presented by way of example only, and are not intended to limit the scope of the disclosures. Indeed, the novel methods and apparatuses described herein may be embodied in a variety of other forms; furthermore, various omissions, substitutions and changes in the form of the embodiments described herein may be made without departing from the disclosures. The accompanying claims and their equivalents are intended to cover such forms or modifications as would fall within the scope of the disclosures.

**Claims**

1. A heat treatment apparatus (1, 201, 301, 401) for heat treating a plurality of substrates (S), the heat treatment apparatus (1, 201, 301, 401) comprising:

   a processing chamber (22, 202, 402) which accommodates the plurality of substrates (S) to be subjected to the heat treatment;
   a substrate holding member (24) which holds the plurality of substrates (S) in a vertical arrangement and is capable of being loaded into/unloaded from the processing chamber (22, 202, 402);
   an induction heating coil (104, 212, 453) which forms an induction magnetic field for induction heating in the processing chamber (22, 202, 402);
   a high frequency power supply (110, 214, 460) which applies high frequency power to the induction heating coil (104, 212, 453); and
   induction heating bodies (N, N', N″) having spiral-shaped parts which are respectively installed to overlap with the plurality of substrates (S) in the processing chamber (22, 202, 402) and generate heat by a flow of induction current generated by applying the high frequency power to the induction heating coil (104, 212, 453).

2. The heat treatment apparatus (1, 201, 301, 401) of Claim 1, wherein the processing chamber (22, 202, 402) is made of a dielectric and the induction heating coil (104, 212, 453) is wound on the periphery of the processing chamber (22, 202, 402).

3. The heat treatment apparatus (1, 201, 301, 401) of Claim 1 or 2, wherein the substrate holding member (24) includes a plurality of substrate holding parts which holds the plurality of substrates (S) respectively.

4. The heat treatment apparatus (1, 201, 301, 401) of Claim 3, wherein the substrate holding member (24) holds the induction heating bodies (N, N', N") such that the induction heating bodies (N, N', N") and the plurality of substrates (S) are alternately held.

5. The heat treatment apparatus (1, 201, 301, 401) of Claim 3, wherein the substrate holding member (24) holds the induction heating bodies (N, N', N") and the induction heating bodies (N, N', N") function as the substrate holding parts.

6. A heat treatment apparatus (1, 201, 301, 401) for heat treating a substrate (S), the heat treatment apparatus (1, 201, 301, 401) comprising:

   a processing chamber (22, 202, 402) which accommodates the substrate (S) to be subjected to the heat treatment;
   a substrate holding part which holds one or more substrates (S) in the processing chamber (22, 202, 402);
   an induction heating coil (104, 212, 453) which forms an induction magnetic field for induction heating in the processing chamber (22, 202, 402);
   a high frequency power supply (110, 214, 460) which applies high frequency power to the induction heating coil (104, 212, 453); and
   induction heating bodies (N, N', N") having spiral-shaped parts which are installed to correspond to the substrates (S) in the processing chamber (22, 202, 402) and generate heat by a flow of induction current generated by applying the high frequency power to the induction heating coil (104, 212, 453).

7. The heat treatment apparatus (1, 201, 301, 401) of Claim 6, wherein the processing chamber (22, 202, 402) is made of a dielectric and the induction heating coil (104, 212, 453) is wound on the outside of the processing chamber (22, 202, 402).

8. The heat treatment apparatus (1, 201, 301, 401) of Claim 6 or 7, wherein the substrate holding part includes a substrate loading table (203, 303, 403) which loads one or more substrates (S) on a single plane.

9. The heat treatment apparatus (1, 201, 301, 401) of one of Claims 6 to 8, wherein the induction heating bodies (N, N', N") are installed below the substrate loading table (203, 303, 403) corresponding to the substrate (S) loaded on the substrate loading table (203, 303, 403).

10. The heat treatment apparatus (1, 201, 301, 401) of one of Claims 6 to 9, wherein the induction heating coil (104, 212, 453) is wound in a plane form on a ceiling wall of the processing chamber (22, 202, 402).

11. The heat treatment apparatus (1, 201, 301, 401) of one of Claims 1 to 10, wherein the induction heating bodies (N, N', N") have a spiral-shaped body (131) and a returning part (132) connecting a central end (131a) of the body (131) and a circumferential end (131b) of the body (131).

12. The heat treatment apparatus (1, 201, 301, 401) of Claim 11, wherein the returning part (132) is larger than the body (131) in terms of electrical conductivity or a sectional area or both.

13. The heat treatment apparatus (1, 201, 301, 401) of one of Claims 1 to 12, wherein the induction heating bodies (N, N', N") include two spiral-shaped bodies (133, 433, 443; 134, 434, 444) which overlap with each other such that an induction current flows into the two spiral-shaped bodies (133, 433, 443; 134, 434, 444) in the same direction when central ends (133a, 433a, 443a; 134a, 434a, 444a) of the spiral-shaped bodies (133, 433, 443; 134, 434, 444) are connected to each other and circumferential ends (133b, 433b, 443b; 134b, 434b, 444b) of the spiral-shaped bodies (133, 433, 443; 134, 434, 444) are connected to each other.

14. The heat treatment apparatus (1, 201, 301, 401) of Claim 13, wherein the two spiral-shaped bodies (133, 433, 443; 134, 434, 444) have the same shape as each other such that one spiral-shaped body (133, 433, 443) is inverted and overlaps with the other spiral-shaped body (134, 434, 444).

15. A heat treatment apparatus (1, 201, 301, 401) for heat treating a substrate (S), the heat treatment apparatus (1, 201, 301, 401) comprising:

   a processing chamber (22, 202, 402) which accommodates the substrate (S) to be subjected to the heat treatment;
   a substrate holding part which holds one or more substrates (S) in the processing chamber (22, 202, 402);
   an induction heating coil (104, 212, 453) which forms an induction magnetic field for induction heating in the processing chamber (22, 202, 402);
   a high frequency power supply (110, 214, 460) which applies high frequency power to the induction heating coil (104, 212, 453); and

induction heating bodies (N, N', N") having spiral-shaped parts which are installed to correspond to the substrate (S) in the processing chamber (22, 202, 402) and generate heat by a flow of induction current generated by applying the high frequency power to the induction heating coil (104, 212, 453),

wherein the induction heating bodies (N, N', N") include a first heating body (N1) installed at a position corresponding to an inner side of the substrate holding part and a second heating body (N2) installed in the outer side of the substrate holding part, the first heating body (N1) and the second heating body (N2) being configured such that two spiral-shaped bodies (133, 433, 443; 134, 434, 444) overlap with each other, with one end (133a, 433a, 443a; 134a, 434a, 444a) of each of the two spiral-shaped bodies (133, 433, 443; 134, 434, 444) being connected to each other and the other end (133b, 433b, 443b; 134b, 434b, 444b) of each of the two spiral-shaped bodies (133, 433, 443; 134, 434, 444) being connected each other, and the two spiral-shaped bodies (133, 433, 443; 134, 434, 444) are configured such that an induction current flows in the same direction, and

wherein the induction heating coil (104, 212, 453) includes a first induction heating coil (456) installed at a position corresponding to the first heating body (N1) and a second induction heating coil (457) installed at a position corresponding to the second heating body (N2), and quantities of heat of the first and second heating bodies (N1) and (N2) are independently adjusted by controlling a current distribution of the first induction heating coil (456) and the second induction heating coil (457).

16. The heat treatment apparatus (1, 201, 301, 401) of Claim 15, wherein the two spiral-shaped bodies (133, 433, 443; 134, 434, 444) constituting the first and second heating bodies (N1; N2) respectively have the same shape and overlap with each other such that one spiral-shaped body (133, 433, 443) is inverted with respect to the other spiral-shaped body (134, 434, 444).

17. The heat treatment apparatus (1, 201, 301, 401) of Claim 15 of 16, wherein the induction heating coil (104, 212, 453) is installed above or below the induction heating bodies (N, N', N") in the processing chamber (22, 202, 402).

18. The heat treatment apparatus (1, 201, 301, 401) of one of Claims 1 to 17, further comprising a uniform heating member (141) which is installed between the substrate (S) held by the substrate holding member (24) and the induction heating bodies (N, N', N").

# FIG. 1

# FIG. 2

Substrate load

# FIG. 3

## FIG. 4

## FIG. 5

## FIG. 6

## FIG. 7

FIG. 8

FIG. 9

FIG. 10

FIG. 11

# FIG. 12

EP 2 472 575 A2

FIG. 13

EP 2 472 575 A2

EP 2 472 575 A2

# FIG. 14

201

Process gas

212  202a

214  216  213  207

206  203  204  205

S  208  N

210  210a  210b  210c  202

EP 2 472 575 A2

# FIG. 15

## FIG. 16

## FIG. 17

FIG. 18

FIG. 19

FIG. 20

443a, 444a

N2

443

444

443b, 444b

FIG. 21

453

456

457

461

460

## FIG. 22

## FIG. 23